# EUROPEAN PATENT APPLICATION

(11) **EP 4 220 954 A1**
(43) Date of publication of application: **02.08.2023**
(21) Application number: 23154015.4
(22) Date of filing: 30.01.2023
(51) Int. Cl.: H03F 3/24, H03F 3/19, H03F 1/30, H03F 3/45, H03F 1/52

(54) **POWER AMPLIFIER WITH FEEDBACK BALLAST RESISTANCE**

(30) Priority: 31.01.2022 US 202217589050
(71) Applicant: Qorvo US, Inc., Greensboro, NC 27409 (US)
(72) Inventor: SCOTT, Baker, San Jose, 95134 (US); WOO, Chong, San Jose, 95134 (US); MAXIM, George, San Jose, 95134 (US)
(74) Representative: D Young & Co LLP

(57) **Abstract**

A power amplifier with feedback ballast resistance is disclosed. In one aspect, a power amplifier cell may receive a bias signal from a bias circuit where the bias circuit includes a feedback loop having an impedance that, from the perspective of the bias signal is relatively low impedance, but from a ballast thermal control perspective provides sufficient resistance to avoid thermal runaway. This feedback loop may be extended to operate with multiple power amplifier cells and provide differential mode thermal control optimized for individual cell bias signal control and common mode thermal control optimized for thermal control of the collective power amplifier cells of the power amplifier.

## Description

### BACKGROUND

### I. Field of the Disclosure

The technology of the disclosure relates generally to power amplifiers and, more specifically, to power amplifiers with ballast resistors to prevent thermal runaway.

### II. Background

Computing devices abound in modern society, and more particularly, mobile communication devices have become increasingly common. The prevalence of these mobile communication devices is driven in part by the many functions that are now enabled on such devices. Increased processing capabilities in such devices means that mobile communication devices have evolved from pure communication tools into sophisticated mobile entertainment centers, thus enabling enhanced user experiences. Mobile communication devices typically include a power amplifier to boost signals for transmission when communicating. The power amplifier may include multiple stages. The use and arrangement of multi-cell power amplifier stages may cause individual amplifiers to generate waste heat. Under the right conditions, such waste heat may contribute to thermal runaway within the power amplifier causing one or more amplifiers to fail. While ballast resistances have been used to reduce the likelihood of thermal runaway, such an approach may lead to significant stage de-biasing as the current rectifies up at mid-power levels, resulting in non-linear performance, which negatively impacts compliance with emerging cellular communication standards and may negatively impact the user experience. Accordingly, there is room for improvement in the formation of power amplifiers that avoid thermal runaway.

### SUMMARY

Particular embodiments are set out in the independent claims. Various optional examples are set out in the dependent claims. Aspects disclosed in the detailed description include a power amplifier with feedback ballast resistance. In particular, a power amplifier cell may receive a bias signal from a bias circuit where the bias circuit includes a feedback loop having an impedance that, from the perspective of the bias signal is relatively low impedance, but from a ballast thermal control perspective provides sufficient resistance to avoid thermal runaway. This feedback loop may be extended to operate with multiple power amplifier cells and provide differential mode thermal control optimized for individual cell bias signal control and common mode thermal control optimized for thermal control of the collective power amplifier cells of the power amplifier. Such circuitry provides sufficient ballast impedance for thermal control while also improving linear performance and avoiding de-biasing individual power amplifier cells.

In this regard in one aspect, a circuit is disclosed. The circuit comprises a power amplifier cell. The circuit also comprises a bias circuit coupled to the power amplifier cell at an input node. The bias circuit is configured to provide a bias signal to the power amplifier cell through the input node. The bias circuit comprises a feedback network. The feedback network is configured to provide differential mode ballasting stability and common mode ballasting stability. The feedback network is also configured to provide a ballast resistance to the bias signal under three hundred ohms (300 Ω).

### BRIEF DESCRIPTION OF THE DRAWINGS

Figure 1A is a circuit diagram of a conventional power amplifier cell having a bias circuit that uses ballast resistance to prevent thermal runaway;
Figure 1B is a circuit diagram of a conventional power amplifier stage having multiple power amplifier cells, each receiving a bias signal through ballast resistance to prevent thermal runaway;
Figure 1C is a graph showing adjacent channel leakage ratio (ACLR) versus power for variously-sized ballast resistances and associated non-linearities;
Figure 2 is a mixed block and circuit diagram of a single-ended power amplifier stage with multiple power amplifier cells receiving bias signals from a bias circuit having a feedback network for differential mode and common mode ballasting to improve linearity while preventing thermal runaway;
Figure 3 is a mixed block and circuit diagram of a differential-ended power amplifier stage with multiple power amplifier cells receiving bias signals from a differential bias circuit having a feedback network for differential mode and common mode ballasting to improve linearity while preventing thermal runaway;
Figure 4 is a mixed block and circuit diagram of a differential-ended power amplifier stage with multiple power amplifier cells receiving bias signals from a unitary bias circuit having two feedback networks for differential mode and common mode ballasting to improve linearity while preventing thermal runaway;
Figure 5 is circuit diagram showing a feedback network within a bias circuit for a single power amplifier cell that also uses an external ballast resistance to improve common mode ballasting;
Figure 6 is a circuit diagram extending the bias circuit with feedback network to a power amplifier stage having multiple power amplifier cells, each with an external ballast resistance to improve common mode ballasting;
Figure 7 is a circuit diagram showing a T-type feedback network within the bias circuit for a single power amplifier cell that also uses an external ballast resistance to improve common mode ballasting;
Figure 8 is a circuit diagram extending the concept of Figure 7 to a power amplifier stage having multiple power amplifier cells each with an external ballast resistance to improve common mode ballasting;
Figure 9 is a circuit diagram showing an L-type feedback network within the bias circuit for a single power amplifier cell without an external ballast resistance;
Figure 10 is a circuit diagram showing the circuitry of the bias circuit that includes a Wilson current mirror that works with the feedback network to provide a bias signal for a single power amplifier cell without an external ballast resistance;
Figure 11 shows the bias circuit of Figure 10 with an external ballast resistance to improve common mode ballasting;
Figure 12 shows the bias circuit of Figure 11 with additional details about the feedback network being a T-type feedback network;
Figures 13A and 13B show a bias circuit having a feedback network, wherein the bias circuit may include added optional single-ended resistive degeneration;
Figure 13C shows a bias circuit having a feedback network, wherein the bias circuit may include added optional double-ended resistive degeneration;
Figure 14 shows an alternate bias circuit having a feedback network with optional resistive degeneration;
Figure 15 is a circuit diagram illustrating how the concepts of the bias circuit of Figure 11 may be extended to a power amplifier stage having multiple power amplifier cells; and

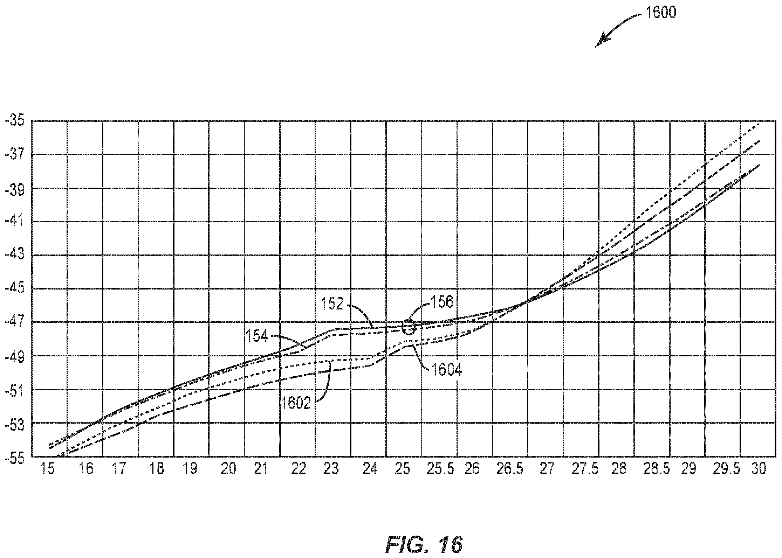

Figure 16 is a graph of ACLR versus power contrasting conventional ballasting techniques with power amplifiers having feedback ballast resistance according to some aspects of the present disclosure.

### DETAILED DESCRIPTION

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Aspects disclosed in the detailed description include a power amplifier with feedback ballast resistance. In particular, a power amplifier cell may receive a bias signal from a bias circuit where the bias circuit includes a feedback loop having an impedance that, from the perspective of the bias signal is relatively low impedance, but from a ballast thermal control perspective provides sufficient resistance to avoid thermal runaway. This feedback loop may be extended to operate with multiple power amplifier cells and provide differential mode thermal control optimized for individual cell bias signal control and common mode thermal control optimized for thermal control of the collective power amplifier cells of the power amplifier. Such circuitry provides sufficient ballast impedance for thermal control while also improving linear performance and avoiding de-biasing individual power amplifier cells.

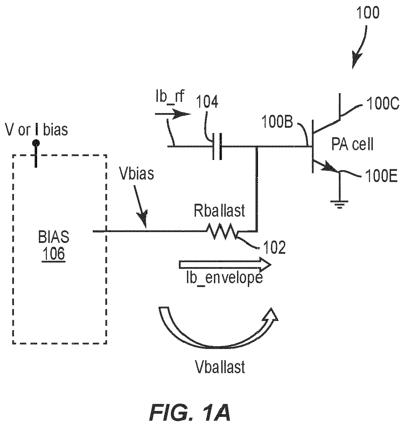

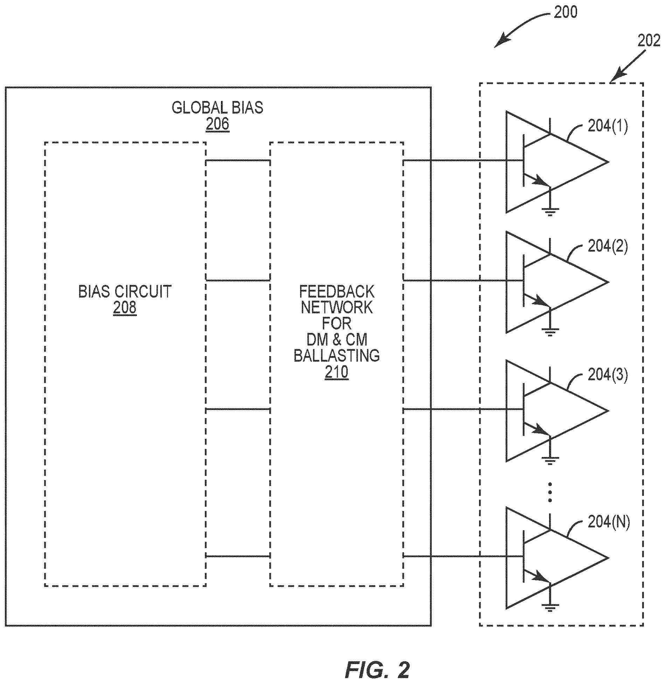

Before addressing aspects of the present disclosure, a brief overview of a conventional power amplifier stage having ballast resistance to prevent thermal runaway is provided with reference to Figures 1A-1C. A discussion of various aspects of a power amplifier with feedback ballast resistance begins below with reference to Figure 2.

In this regard, Figure 1A is a circuit diagram of a conventional power amplifier cell 100 having a ballast resistance 102, which may be a single ballast resistor, to prevent thermal runaway. The power amplifier cell 100 may be a bipolar junction transistor (BJT) having a collector 100C, a base 100B, and an emitter 100E. The base 100B receives a radio frequency (RF) current (Ib_rf) through a capacitor 104 and a ballast current (Ib_envelope) through the ballast resistance (Rballast) 102. The ballast current Ib_envelope is set by a bias circuit 106. The bias circuit 106 knows the value of the ballast resistance 102 and can set a voltage level Vballast by controlling the ballast current Ib_envelope. Setting the voltage level Vballast changes the voltage at the base 100B, allowing for bias control of the power amplifier cell 100. When current at the base 100B increases due to Ib_rf, the voltage Vballast will help pull the current level back down to levels where thermal runaway is mitigated.

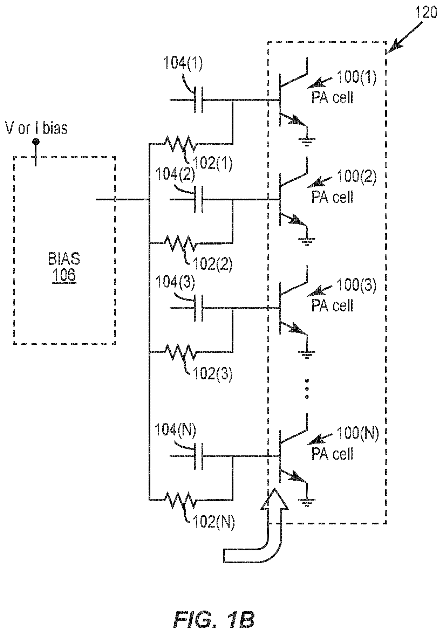

Using ballast resistance composed of one or more ballast resistors to prevent thermal runaway may be extended to a power amplifier stage having multiple power amplifier cells as better illustrated in Figure 1B. Specifically, a power amplifier stage 120 may include multiple power amplifier cells 100(1)-100(N). Each power amplifier cell 100(1)-100(N) may have an associated ballast resistance 102(1)-102(N) to prevent thermal runaway. Each power amplifier cell 100(1)-100(N) receives an RF signal through a respective capacitor 104(1)-104(N). A bias circuit 106 may provide a bias signal to each power amplifier cell 100(1)-100(N) through the ballast resistors 102(1)-102(N).

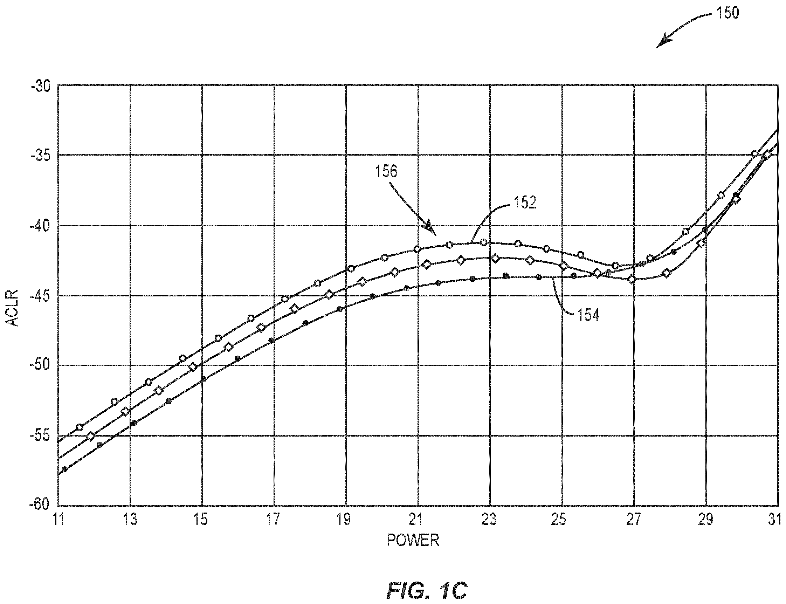

The presence of a ballast resistance 102 for a power amplifier cell 100 does provide protection against thermal runaway loosely proportional to the size of the ballast resistor, with larger resistors providing greater protection. However, as seen by graph 150 in Figure 1C, the improved thermal control comes at the cost of non-linear performance of the adjacent channel leakage ratio (ACLR) versus power. Specifically, line 152 shows a relatively large ballast resistance (e.g., greater than five hundred ohms (> 500 Ω)) while line 154 shows a relatively small ballast resistance (e.g., ≈ 300 Ω). Non-linearities show up as a "back-up hump" 156. Line 154 is the most linear, but still has an ACLR of around -43 decibels (dB) near the hump 156. The fourth generation (4G) of cellular standards tolerated ACLRs of around mid-thirties dB, and thus, lines 152 and 154 were both generally acceptable for devices operating under 4G standards. However, the advent of fifth generation (5G) standards requires in excess of -45 dB in the ranges of interest. Accordingly, the conventionally-sized ballast resistors (e.g., > 300 Ω) are no longer able to provide acceptable ACLRs. While smaller ballast resistors may be used, simply reducing the size of the ballast resistor will negatively impact thermal control and risk damage to the power amplifier stage.

While emitter ballasting is possible, emitter ballasting hurts output power and efficiency. These disadvantages make emitter ballasting unsuitable for most mobile applications. Accordingly, there remains room for improvement in providing thermal control while providing desired bias performance. A feedback network may be added to a bias circuit to provide improved common mode and differential mode ballasting for power amplifier stages. The feedback network allows the external ballasting resistance (e.g., ballast resistor 102) to be reduced or eliminated such that the bias signal from the bias circuit sees a relatively small resistance, but the resistance available to provide thermal control may still be relatively large (e.g., > 250-300 Ω).

As used herein, differential mode ballasting refers to individual ballasting to provide thermal control to an individual power amplifier cell. Further, as used herein, common mode ballasting refers to ballasting such that all the power amplifier cells within a power amplifier stage are thermally controlled.

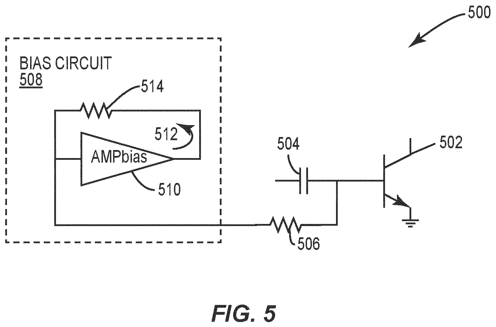

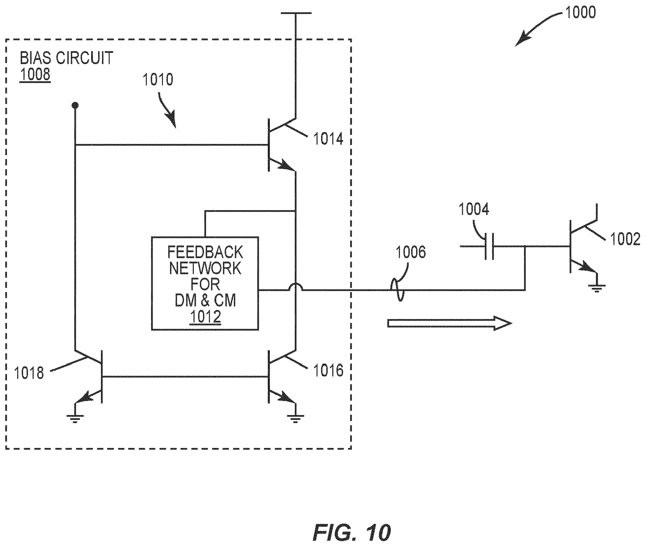

Figure 2 provides a diagram of a circuit 200 that includes a power amplifier stage 202 having a plurality of power amplifier cells 204(1)-204(N). The power amplifier stage 202 may be a single-ended power amplifier stage. The power amplifier stage 202 may receive bias signals from a global bias network 206 that has a bias circuit 208 and a feedback network 210. The feedback network 210 includes circuitry to enable differential mode ballasting and common mode ballasting. The feedback network 210 has a loop gain as explained in greater detail below. More details on the bias circuit 208 are provided below beginning with reference to Figure 10. More details about the feedback network 210 are provided below beginning with reference to Figure 5. Before moving to those details, the breadth of application of the present disclosure is expanded.

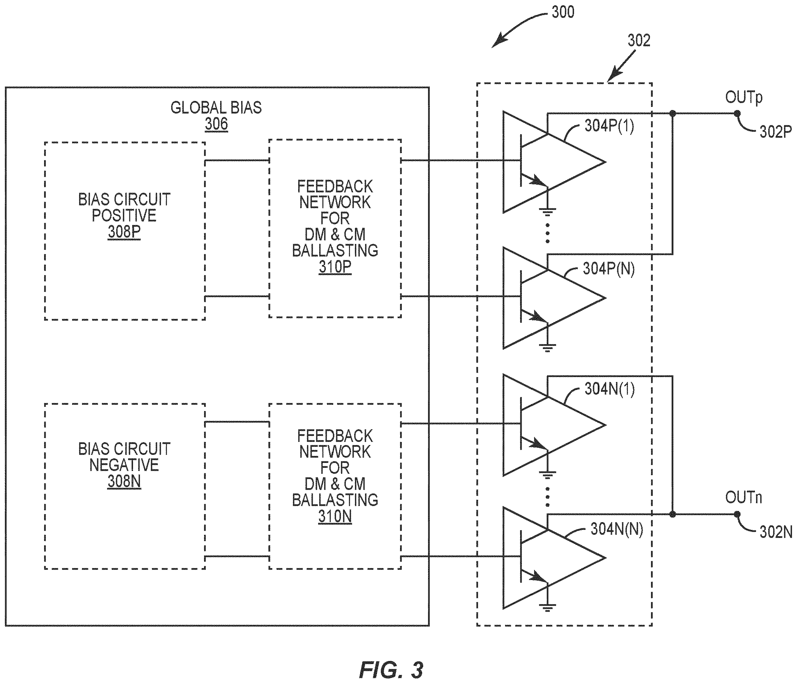

In this regard, the concepts of the present disclosure may be applied to a differential power amplifier stage as shown by circuit 300 in Figure 3. The circuit 300 includes a differential power amplifier stage 302 having a differential output 302P, 302N and a plurality of power amplifier cells 304P(1)-304P(N), 304N(1)-304N(N). The power amplifier stage 302 may receive bias signals from a global bias network 306 that has a positive bias circuit 308P and a negative bias circuit 308N. Additionally, the global bias network 306 may include a positive feedback network 310P and a negative feedback network 310N. The positive feedback network 310P provides bias signals to the positive power amplifier cells 304P(1)-304P(N), and the negative feedback network 310N provides bias signals to the negative power amplifier cells 304N(1)-304N(N). As with the feedback network 210 of Figure 2, the feedback networks 310P, 310N include circuitry to enable differential mode and common mode ballasting.

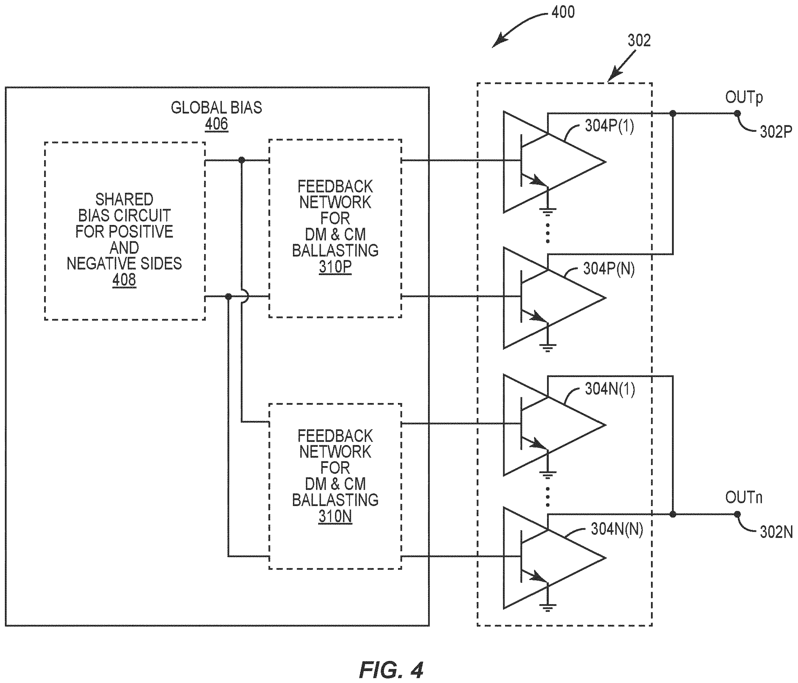

Instead of a dedicated positive bias circuit 308P and negative bias circuit 308N, the bias circuit may be shared. Thus, as illustrated in circuit 400 in Figure 4, a global bias network 406 may include a shared bias circuit 408 that generates bias signals and uses separate feedback networks 310P, 310N. In other regards, the circuit 400 and elements thereof are substantially similar to the circuit 300 of Figure 3 and numbers are reused to show common functionality.

For simplicity, more details about the feedback network are initially shown relative to a generic bias circuit and a single power amplifier cell. Thus, Figure 5 illustrates a circuit 500 that has a single power amplifier cell 502. An RF signal is provided to a base of the power amplifier cell 502 through a capacitor 504 or said another way, the capacitor 504 is configured to receive an RF input signal. In this regard, both the base of the power amplifier cell 502 and the capacitor 504 may be considered coupled to an input node. A ballast resistor 506 is also coupled to the base of the power amplifier cell 502 via the input node and provides a bias signal thereto. A bias circuit 508 generates the bias signal from a bias amplifier circuit 510. The bias amplifier circuit 510 includes a feedback network 512 that includes, at a minimum, a feedback impedance 514 such as a feedback resistor. Use of the feedback network 512 allows the ballast resistor 506 to have a relatively low value (e.g., less than approximately 150 Ω, and more specifically less than approximately 100 Ω, and even more specifically less than approximately 50 Ω), but still provide desired common mode ballasting. The remainder of the thermal control is provided by the feedback impedance 514, which may be a higher value resistor (e.g., 200-295 Q such that the sum of the resistance seen by the base is around 300+ Ω). While the feedback impedance 514 may be relatively large, the bias signal sees a much lower impedance as the sum of the resistance is divided by the loop gain of the feedback loop. Further examples will be provided below. As a further note of nomenclature, approximately as used herein means within five percent (5%).

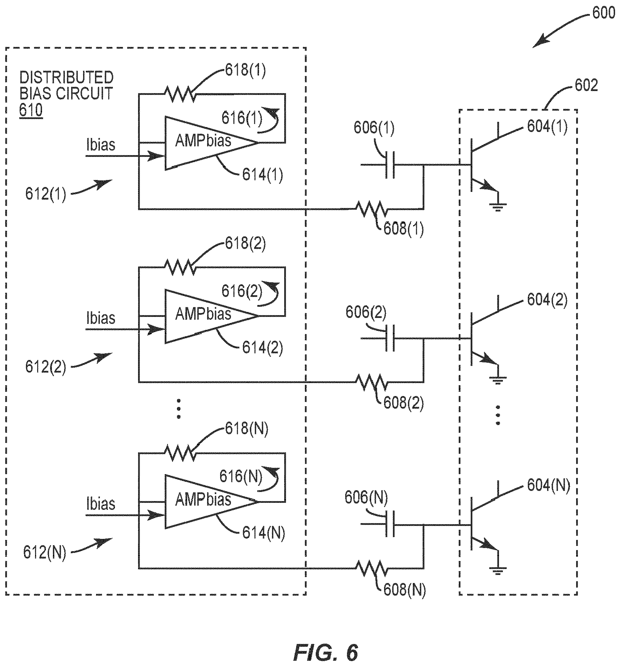

Figure 6 shows a circuit 600 in which the concepts of the circuit 500 of Figure 5 are expanded to cover multiple power amplifier cells. Specifically, the circuit 600 has a power amplifier stage 602 having multiple power amplifier cells 604(1)-604(N). RF signals are provided to respective bases of the power amplifier cells 604(1)-604(N) through capacitors 606(1)-606(N). Respective ballast resistors 608(1)-608(N) are also coupled to the bases of the power amplifier cells 604(1)-604(N) and provide respective bias signals thereto. A global bias circuit 610 includes respective bias circuits 612(1)-612(N) that generate the respective bias signals from bias amplifier circuits 614(1)-614(N). The bias circuits 612(1)-612(N) each include a respective feedback network 616(1)-616(N) that includes, at a minimum, a feedback impedance 618(1)-618(N) such as a feedback resistor. Operation is similar to that discussed above for circuit 500. It should be appreciated that this concept may be extended to a differential power amplifier stage.

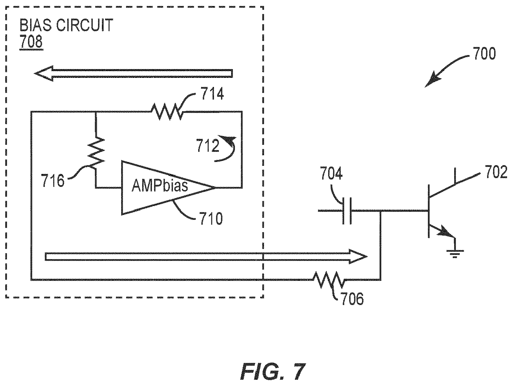

The feedback impedance may be arranged in a variety of ways, but an exemple arrangement is a T-type structure as illustrated in Figure 7. Specifically, Figure 7 illustrates a circuit 700 that has a power amplifier cell 702. An RF signal is provided to a base of the power amplifier cell 702 through a capacitor 704. A ballast resistor 706 is also coupled to the base of the power amplifier cell 702 and provides a bias signal thereto. A bias circuit 708 generates the bias signal from a bias amplifier circuit 710. The bias amplifier circuit 710 includes a feedback network 712 that includes a T-type resistor arrangement having a resistor 714 and a resistor 716. The remainder of the T is provided by the ballast resistor 706.

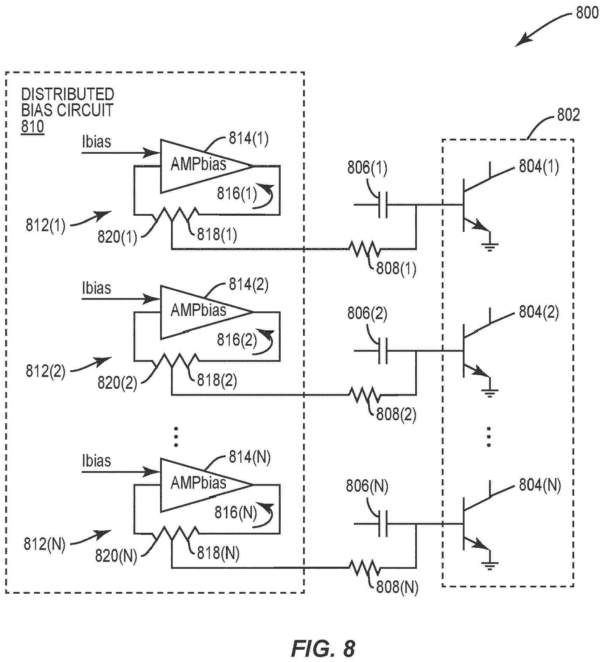

Again, the concepts may be extended to a power amplifier stage having multiple power amplifier cells. In this regard, Figure 8 illustrates a circuit 800 that has a power amplifier stage 802 having multiple power amplifier cells 804(1)-804(N). RF signals are provided to respective bases of the power amplifier cells 804(1)-804(N) through capacitors 806(1)-806(N). Respective ballast resistors 808(1)-808(N) are also coupled to the bases of the power amplifier cells 804(1)-804(N) and provide respective bias signals thereto. A global bias circuit 810 includes respective bias circuits 812(1)-812(N) that generate the respective bias signals from bias amplifier circuits 814(1)-814(N). The bias circuits 812(1)-812(N) each include a respective feedback network 816(1)-816(N) that includes a T-type resistor arrangement having a resistor 818(1)-818(N) and a resistor 820(1)-820(N). It is possible that the resistors 818(1)-818(N) and 820(1)-820(N) may be combined with a central tap. It should be appreciated that this concept may be extended to a differential power amplifier stage.

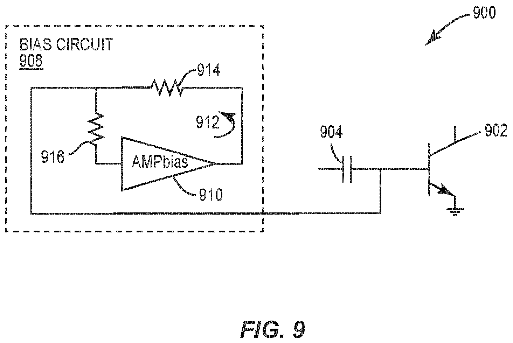

While the examples of the circuits 500-800 of Figures 5-8 contemplate external ballast resistors being used to support the common mode ballasting, the present disclosure is not so limited, and the external ballast resistors may be eliminated and changed to an L-type impedance as better seen in Figure 9. Specifically, a circuit 900 includes a power amplifier cell 902. An RF signal is provided to a base of the power amplifier cell 902 through a capacitor 904. A bias circuit 908 generates a bias signal from a bias amplifier circuit 910. The bias amplifier circuit 910 includes a feedback network 912 that includes an L-type resistor arrangement having a resistor 914 and a resistor 916. Values of the resistors 914, 916 may be chosen to provide an appropriate bias signal and desired thermal control. While not illustrated, this concept can be expanded to a plurality of power amplifier cells in a power amplifier stack and may be extended to a differential amplifier stack.

Figures 10-15 illustrate bias circuits that may be used with the present disclosure with the understanding that other bias circuits may be used. In general, a current mirror may be used such as a Wilson or Widlar current mirror. Still other types of feedback mirrors may also be used.

Turning to Figure 10, a circuit 1000 is illustrated. The circuit 1000 has a power amplifier cell 1002. An RF signal is provided to a base of the power amplifier cell 1002 through a capacitor 1004. A bias signal 1006 is also provided to the base of the power amplifier cell 1002. A bias circuit 1008 generates the bias signal 1006 from a bias amplifier circuit 1010. The bias amplifier circuit 1010 includes a feedback network 1012. The bias amplifier circuit 1010 is a Wilson current mirror having a first transistor 1014, a second transistor 1016, and a third transistor 1018. An emitter of the first transistor 1014 is coupled to a collector of the second transistor 1016. The bases of the second and third transistors 1016, 1018 may be coupled as well. The collector of the third transistor 1018 may be coupled to the base of the first transistor 1014. The feedback network 1012 may couple the emitter of the first transistor 1014 to the bases of the second and third transistors 1016, 1018 and provide the bias signal 1006.

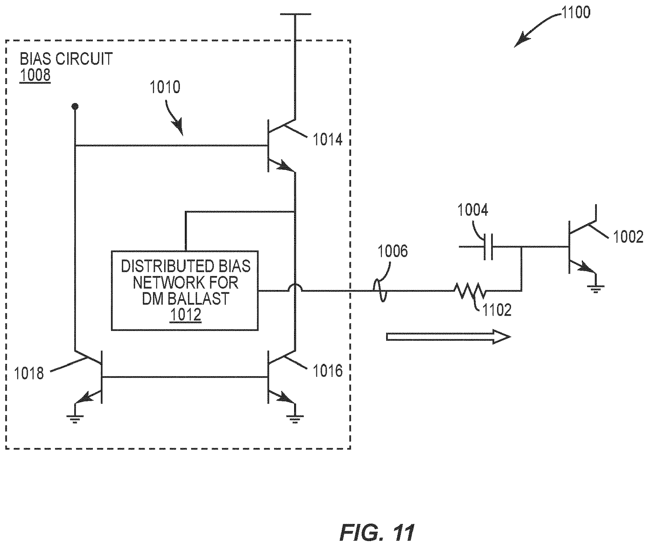

While the circuit 1000 omits an external ballast resistor, a circuit 1100 as illustrated in Figure 11 adds a ballast resistor 1102 for improved common mode ballasting. The remaining elements of circuit 1100 are substantially identical to those of the circuit 1000 and numbers are reused.

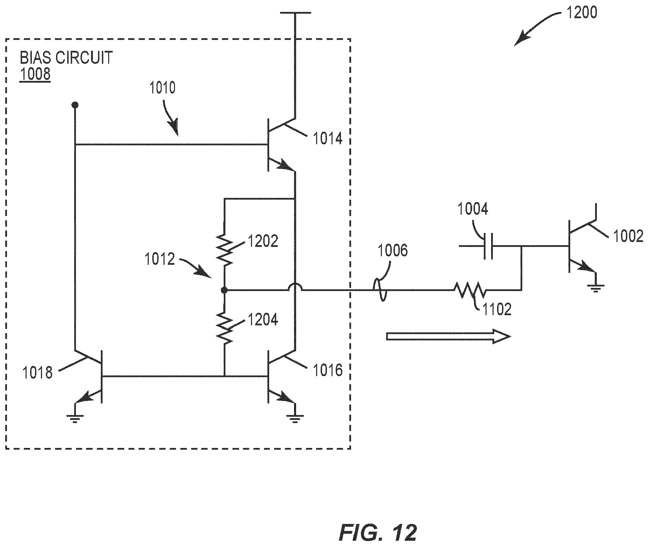

Combining the details of the circuit 700 of Figure 7 and the circuit 1100 results in circuit 1200 illustrated in Figure 12. Many of the elements from circuit 1100 are the same, but the details of the feedback network 1012 are expanded to show resistors 1202, 1204. The resistor 1202 provides differential mode ballasting and the resistor 1102 provides common mode ballasting. The resistors 1102, 1202, 1204 are arranged in a T-shaped configuration.

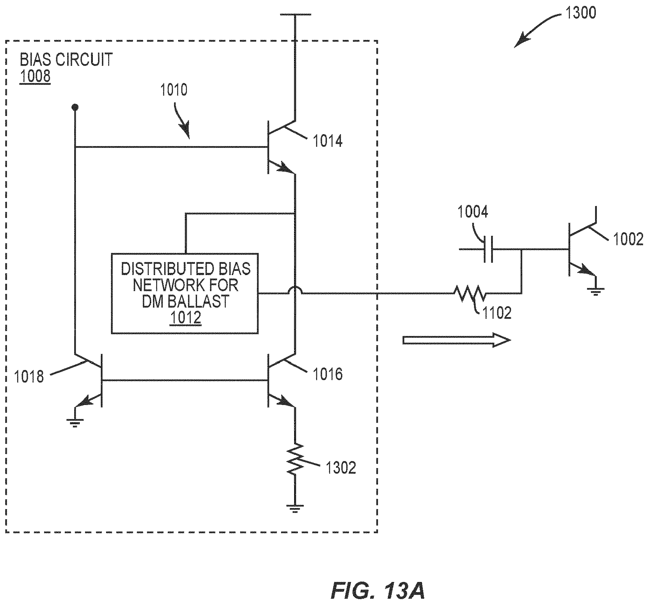

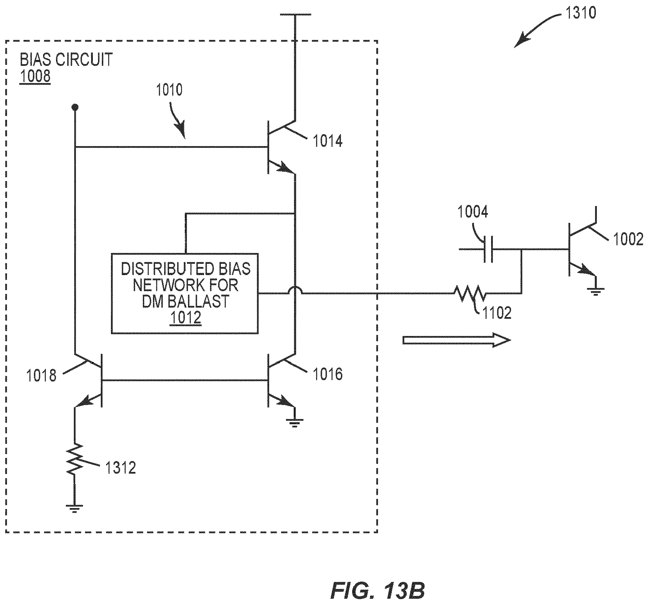

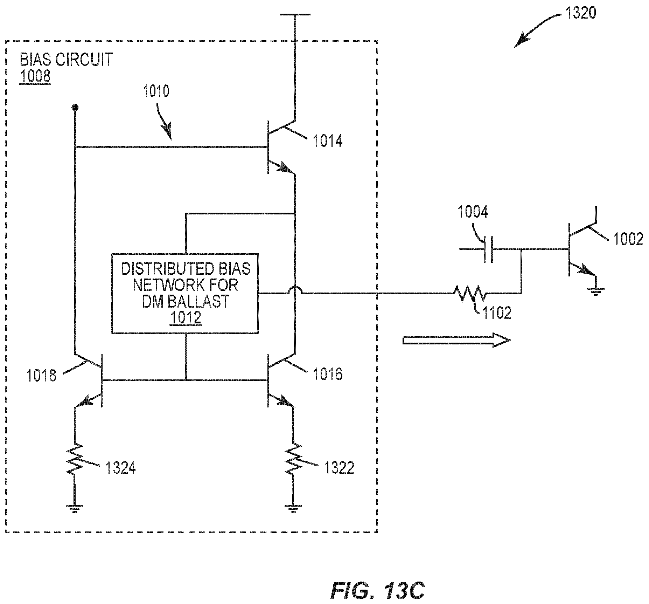

Note that the bias circuit 1008 may be changed by adding resistive degeneration as better illustrated in Figures 13A-13C. Circuit 1300 in Figure 13A is similar to the circuit 1100 of Figure 11, but adds a degenerative resistance 1302 to the second transistor 1016. Similarly, circuit 1310 in Figure 13B adds a degenerative resistance 1312 to the third transistor 1018. Circuit 1320 in Figure 13C adds a first degenerative resistance 1322 to the second transistor 1016 and a second degenerative resistance 1324 to the third transistor 1018.

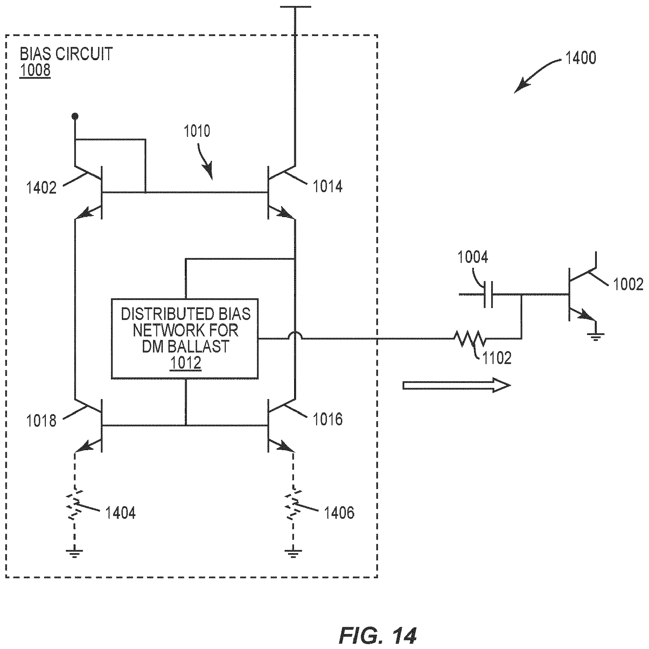

Another variation on the bias circuit is seen in circuit 1400 in Figure 14. The Wilson current mirror has had a fourth transistor 1402 added, and may have optional degenerative resistances 1404, 1406 (either one or both).

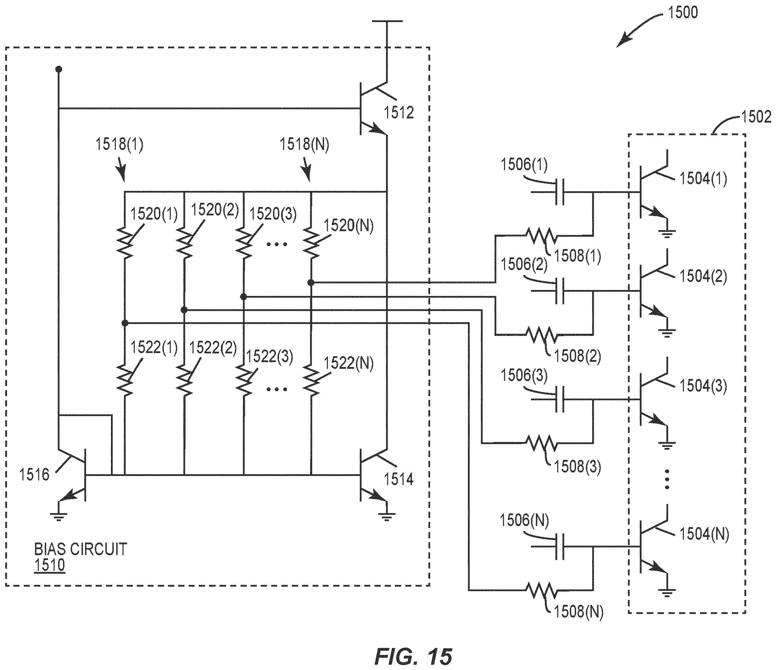

As previously indicated, the concepts of the present disclosure may be extended to power amplifier stacks having a plurality of power amplifier cells. It should be appreciated that the power amplifier stack may include a single-ended output or a differential output. In this regard, Figure 15 illustrates a circuit 1500 having a power amplifier stack 1502 with power amplifier cells 1504(1)-1504(N). RF signals are provided to respective bases of the power amplifier cells 1504(1)-1504(N) through capacitors 1506(1)-1506(N). Respective ballast resistors 1508(1)-1508(N) are also coupled to the bases of the power amplifier cells 1504(1)-1504(N) and provide respective bias signals thereto. A global bias circuit 1510 includes a Wilson current mirror bias circuit formed from transistors 1512, 1514, and 1516 that generate a bias signal that is split amongst respective feedback networks 1518(1)-1518(N) that include a T-type resistor arrangement having a resistor 1520(1)-1520(N) and a resistor 1522(1)-1522(N). It should be appreciated that this concept may be extended to a differential power amplifier stage.

The advantages of various aspects of the present disclosure may be seen in graph 1600 which again plots ACLR against power. Lines 152, 154 from Figure 1C are provided showing the back-up hump 156. In contrast, circuits using a T-shaped feedback network in a bias circuit show improved linearity in lines 1602, 1604. Thus, circuits described herein provide desired linearity and thermal control to better meet the needs of emerging cellular standards.

A computer readable medium may include non-transitory type media such as physical storage media including storage discs and solid state devices. A computer readable medium may also or alternatively include transient media such as carrier signals and transmission media. A computer-readable storage medium is defined herein as a non-transitory memory device. A memory device includes memory space within a single physical storage device or memory space spread across multiple physical storage devices.

The previous description of the disclosure is provided to enable any person skilled in the art to make or use the disclosure. Various modifications to the disclosure will be readily apparent to those skilled in the art, and the generic principles defined herein may be applied to other variations. Thus, the disclosure is not intended to be limited to the examples and designs described herein but is to be accorded the widest scope consistent with the principles and novel features disclosed herein.

Thus, from one perspective, there has now been described a power amplifier with feedback ballast resistance is disclosed. In one aspect, a power amplifier cell may receive a bias signal from a bias circuit where the bias circuit includes a feedback loop having an impedance that, from the perspective of the bias signal is relatively low impedance, but from a ballast thermal control perspective provides sufficient resistance to avoid thermal runaway. In some examples, this feedback loop may be extended to operate with multiple power amplifier cells and provide differential mode thermal control optimized for individual cell bias signal control and common mode thermal control optimized for thermal control of the collective power amplifier cells of the power amplifier.

Further examples of feature combinations taught by the present disclosure are set out in the following numbered clauses:
1. A circuit comprising:
   a power amplifier cell; and
   a bias circuit coupled to the power amplifier cell at an input node, the bias circuit configured to provide a bias signal to the power amplifier cell through the input node, the bias circuit comprising:
      a feedback network configured to:
      provide differential mode ballasting stability and common mode ballasting stability; and
      provide a ballast resistance to the bias signal under three hundred ohms (300 Ω).
2. The circuit of clause 1, wherein the power amplifier cell comprises a bipolar junction transistor (BJT).
3. The circuit of clause 2, further comprising a ballast resistor positioned between the bias circuit and a base of the BJT.
4. The circuit of clause 3, wherein the ballast resistor is less than 150 Ω.
5. The circuit of clause 3 or 4, wherein the ballast resistor is less than approximately 50 Ω.
6. The circuit of any preceding clause, further comprising a capacitor coupled to the input node and configured to receive a radio frequency (RF) input signal.
7. The circuit of any preceding clause, wherein the bias circuit is coupled to a power amplifier stack and the power amplifier cell is one of a plurality of power amplifier cells within the power amplifier stack.
8. The circuit of clause 7, wherein the power amplifier stack comprises a differential output.
9. The circuit of clause 7, wherein the power amplifier stack comprises a single-ended output.
10. The circuit of any preceding clause, wherein the bias circuit comprises a Wilson current mirror.
11. The circuit of any preceding clause, wherein the bias circuit comprises a Widlar current mirror.
12. The circuit of any preceding clause, wherein the feedback network comprises a T-shaped impedance circuit.
13. The circuit of clause 3, wherein the feedback network comprises a first resistor serially coupled to the ballast resistor and, collectively, the first resistor and the ballast resistor provide a resistance of approximately 300 Ω.
14. The circuit of any preceding clause, wherein the feedback network comprises a loop gain and impedance seen by the bias signal is based on the loop gain.

## Claims

1. A circuit comprising:
a power amplifier cell; and
a bias circuit coupled to the power amplifier cell at an input node, the bias circuit configured to provide a bias signal to the power amplifier cell through the input node, the bias circuit comprising:
a feedback network configured to:
provide differential mode ballasting stability and common mode ballasting stability; and
provide a ballast resistance to the bias signal under three hundred ohms (300 Ω).

2. The circuit of claim 1, wherein the power amplifier cell comprises a bipolar junction transistor (BJT).

3. The circuit of claim 2, further comprising a ballast resistor positioned between the bias circuit and a base of the BJT.

4. The circuit of claim 3, wherein the ballast resistor is less than 150 Ω.

5. The circuit of claim 3 or 4, wherein the ballast resistor is less than approximately 50 Ω.

6. The circuit of any preceding claim, further comprising a capacitor coupled to the input node and configured to receive a radio frequency (RF) input signal.

7. The circuit of any preceding claim, wherein the bias circuit is coupled to a power amplifier stack and the power amplifier cell is one of a plurality of power amplifier cells within the power amplifier stack.

8. The circuit of claim 7, wherein the power amplifier stack comprises a differential output.

9. The circuit of claim 7, wherein the power amplifier stack comprises a single-ended output.

10. The circuit of any preceding claim, wherein the bias circuit comprises a Wilson current mirror.

11. The circuit of any preceding claim, wherein the bias circuit comprises a Widlar current mirror.

12. The circuit of any preceding claim, wherein the feedback network comprises a T-shaped impedance circuit.

13. The circuit of claim 3, wherein the feedback network comprises a first resistor serially coupled to the ballast resistor and, collectively, the first resistor and the ballast resistor provide a resistance of approximately 300 Ω.

14. The circuit of any preceding claim, wherein the feedback network comprises a loop gain and impedance seen by the bias signal is based on the loop gain.
